# EUROPEAN PATENT SPECIFICATION

(11) **EP 1 990 841 B1**
(45) Date of publication and mention of the grant of the patent: **08.01.2020**
(21) Application number: 08014020.5
(22) Date of filing: 10.11.2006
(51) Int. Cl.: H01L 33/12, H01L 33/32, H01L 33/04

(54) **Superlattice strain relief layer for semiconductor devices**
Übergitter-Zugentlastungsschicht für Halbleitervorrichtungen
Couche super-réseau à soulagement de traction pour dispositifs à semiconducteurs

(30) Priority: 14.11.2005 US 736362 P; 17.02.2006 US 356769
(43) Date of publication of application: 12.11.2008
(62) Divisional of application: 06123849.9
(73) Proprietor: Palo Alto Research Center Incorporated, Palo Alto, California 94304 (US)
(72) Inventor: Kneissl, Michael A., 10405 Berlin (DE); Yang, Zhihong, Sunnyvale CA 94086 (US); Wong, William S., San Carlos, CA 94070 (US); Teepe, Mark R., Menlo Park, CA 94025 (US); Knollenberg, Clifford F., Mountain View, CA 94040 (US)
(74) Representative: Grünecker Patent- und Rechtsanwälte PartG mbB

(56) References cited:
- JP-A- 2001 068 733
- JP-A- 2004 119 807
- US-A1- 2002 195 606
- ADIVARAHAN V ET AL: "250nmAlGaN light-emitting diodes" APPLIED PHYSICS LETTERS, AIP, AMERICAN INSTITUTE OF PHYSICS, MELVILLE, NY, US, vol. 85, no. 12, 1 January 2004 (2004-01-01), pages 2175-2177, XP012062578 ISSN: 0003-6951
- WANG T ET AL: "Fabrication of high performance of AlGaN/GaN-based UV light-emitting diodes" JOURNAL OF CRYSTAL GROWTH, ELSEVIER, AMSTERDAM, NL, vol. 235, no. 1-4, 1 February 2002 (2002-02-01), pages 177-182, XP004333457 ISSN: 0022-0248
- CHEN C Q ET AL: "AlGaN layers grown on GaN using strain-relief interlayers" APPLIED PHYSICS LETTERS, AIP, AMERICAN INSTITUTE OF PHYSICS, MELVILLE, NY, US, vol. 81, no. 26, 23 December 2002 (2002-12-23), pages 4961-4963, XP012032869 ISSN: 0003-6951
- NAKAMURA S ET AL: "InGaN/GaN/AlGaN-Based LAser Diodes with Modulation-Doped Strained-Layer Superlattices" JAPANESE JOURNAL OF APPLIED PHYSICS, JAPAN SOCIETY OF APPLIED PHYSICS, TOKYO,JP, vol. 36, no. 12A, 1 December 1997 (1997-12-01), pages 1568-1571, XP002248676 ISSN: 0021-4922

## Description

### BACKGROUND OF THE INVENTION

### 1. Field of the Invention.

The present invention is related generally to the field of light emitting diode devices, and more specifically to an architecture for an improved high-AI content, low defect heterostructure quantum well surface emitting light emitting diode device.

### 2. Description of the Prior Art.

In the III-V compound semiconductor family, the nitrides have been used to fabricate visible wavelength light emitting diode active regions. They also exhibit a sufficiently high bandgap to produce devices capable of emitting light in the ultraviolet, for example wavelengths between 300 and 400 nanometers. In particular, InAIGaN systems have been developed and implemented in visible and UV spectrum light emitting diodes (LEDs), such as disclosed in U.S. Patent 6,875,627 to Bour et al. These devices are typically formed on an Al₂O₃ (sapphire) substrate, and comprise thereover a GaN:Si or AlGaN template layer, an AlGaN:Si/GaN superlattice structure for reducing optical leakage, an n-type electrode contact layer, a GaN n-type waveguide, an InGaN quantum well heterostructure active region, and a GaN p-type waveguide region. In addition, the complete device may also have deposited thereover a p-type AlGaN:Mg cladding layer and a capping layer below a p-type electrode.

While significant improvements have been made in device reliability, optical power output, and mode stability, the performance of the nitride-based light emitting diode emitting in the ultraviolet (UV) is still far inferior to that of blue or green light emitting diode. It is particularly true that for the UV light emitting diodes, the nature of the substrate and template layer have a critical impact on the overall device performance. For example, electrical resistance between the structural layers of the device significantly effects optical output. While Al₂0₃ (sapphire) as a substrate has numerous advantages, the AIGaN template layer formed over the typical Al₂0₃ substrate posses high series resistance due to limited doping capabilities. Furthermore, the crystallographic structure of the device layers plays a key role in the device's operational characteristics, and the AIGaN template layer provides a relatively poor crystalline template.

The dislocation densities in AIGaN or AIN template layers on sapphire are typically in the mid 10⁹ to high 10¹⁰ cm⁻² range. As a consequence, the external quantum efficiencies of deep UV light emitting diodes in the 250 nm to 350 nm range are still below 2% even for the very best devices (external quantum efficiencies near 50% have been demonstrated for blue GaN-based LED structures). The high dislocation densities in AIGaN or AIN template layers on sapphire also pose significant problems for the light emitting diode device lifetimes.

GaN epitaxial layers on sapphire substrates have proven to be a better template for InGaAlN film growth, providing excellent optoelectronic quality for visible light emitting diode devices and reasonable dislocation densities. The dislocation densities in GaN template layers on sapphire are typically in the low 10⁹ to mid 10⁷ cm⁻² ranges. Accordingly, sapphire with a GaN template layer is the preferred foundation for visible GaN-based light emitting diodes.

The output wavelength of the light emitting diode is inversely related to the Al content in the multiple quantum well heterostructure (MQWH) active region of the device. Thus, in order to obtain shorter wavelength devices, such as those emitting in the UV, the Al content of the HQWH region must be increased over that found in devices emitting in the visible spectrum. However, increasing the Al content presents a number of structural and device performance problems.

Furthermore, efforts to improve the quality of the LED structure in the ultraviolet range on GaN/sapphire template have presented significant challenges due to the large lattice mismatch between the epitaxial layers formed over the GaN crystallographic template which is known to lead to strain-induced cracking. This lattice mismatch is exacerbated when the Al content of layers formed above the GaN/sapphire system increases. Yet, as previously mentioned, an increased Al content (e.g., up to -50% in the MQWH active region of a 280nm light emitting diode, and 60% to 70% in the surrounding AIGaN current and optical confinement layers) is required to obtain devices which emit in the UV. A UV InAlGaN heterostructure grown on GaN/sapphire is under tensile stress, which causes cracking of the AIGaN epitaxial layers when the critical layer thickness is exceeded. The critical thickness for an AIGaN film with a 50% aluminum mole fraction is about 20-50nm, which is much too thin for realizing a usable device structure in the deep UV. Efforts to provide strain relief to accommodate the lattice mismatch have heretofore proven unsuccessful or impractical.

Various groups have published approaches to dealing with these shortcomings. For example, Han et al., Appl. Phys. Lett, Vol 78, 67 (2001), discuss the use of a single AIN interlayer formed at low temperatures to avoid strain development. This low-temperature AIN interlayer approach has proven unsuccessful in the case of heterostructure growth with high Al mole fractions. Nakamura et al., J. J. Appl. Phys., vol. 36, 1568 (1997) has suggested short period GaN/AlGaN superlattice layers as a way of extending the critical layer thickness of AIGaN films grown pseudomorphically on GaN/sapphire. But the average Al mole fraction in these AlGaN/GaN systems is at such a low level (-10% or less) that it is not compatible with deep UV light emitting diodes. Chen et al., Appl. Phys. Lett., vol. 81, 4961 (2002) suggests an AIGaN/AIN layer as a dislocation filter for an AIGaN film on a AlGaN/sapphire template. But again, the AlGaN/sapphire template presents the aforementioned series resistance problem. Adivarahan et al., Appl. Phys. Lett. Vol. 85, 2175 (2004) follows the method proposed by Chen et al. and uses a AIGaN/AIN superlattice as a strain-relief layer for a UV-LED structure, thus incurring in the problems mentioned above.

There is a need for a deep UV light emitting diode apparatus with improved operation characteristics, and therefore, there is a need for a method and structure facilitating a high Al content MQWH active region which is free from cracking and related damage.

### SUMMARY OF THE INVENTION

Accordingly, the present invention is directed to a GaN/AIN strain relief layer that enables the growth of crack-free thick AlGaN films with high aluminum content on a GaN/sapphire template. The present invention is defined by attached claim 1. Further embodiments are disclosed in the dependent claims.

According to one aspect of the present invention, an ultraviolet InAIGaN light emitting diode heterostructure is grown on a GaN/sapphire template with a GaN/AIN short period superlattice (SPSL) strain relief layer. The short period superlattice strain relief layer enables the growth of a high-quality and crack-free high aluminum content InAIGaN MQWH active region, providing a light emitting diode capable of emitting in the deep UV wavelength range. The GaN/AIN short period superlattice strain relief layer may be formed in conditions (e.g., temperature and pressure) consistent with the growth of other layers of the device for efficient production.

Optionally, after growth, the deep UV light emitting diode may be flip-chip bonded onto a heatsink and the sapphire substrate removed by excimer laser lift-off. The absorbing GaN template layer and some or all of the GaN/AIN short period superlattice strain relief layer may also be removed, for example by dry-etching (e.g. by CAIBE). Removal of the GaN/sapphire template allows for improved light extraction through the UV-transparent AIGaN current spreading layer and results also in lower operating voltages due to the vertical device structure.

According to another embodiment of the present invention, a GaN/AIN strain relief layer enables the growth of low defect, relatively high Al-content films over a GaN/sapphire template useful for non-optical applications, such as the high electron mobility transistors (HEMTs) and the like.

According to a second aspect the present invention provides a semiconductor structure, comprising:
a substrate;
a template layer formed over and in contact with said substrate;
a superlattice structure formed over and in contact with said template layer, said superlattice structure comprising a plurality of layer pairs, a first layer of said layer pairs being AIN and a second layer of said layer pairs being GaN.

According to an embodiment of the second aspect, said substrate is formed of Al₂O₃.

According to another embodiment of the second aspect, said template layer is formed of GaN.

According to a third aspect the present invention provides a semiconductor light emitting diode structure, comprising:
a substrate;
a template layer formed over and in contact with said substrate;
a superlattice structure formed over and in contact with said template layer, said superlattice structure comprising:
   a plurality of layer pairs, a first layer of said layer pairs being AIN and a second layer of said layer pairs being GaN: and
a multiple quantum well heterostructure of a composition including at least 25% aluminum, formed over said superlattice structure.

According to an embodiment of the third aspect, said substrate is formed of Al₂O₃.

According to another embodiment of the third aspect, said template layer is formed of GaN.

According to another embodiment of the third aspect, said superlattice structure comprises at least 70 but no more than 90 layer pairs.

According to another embodiment of the third aspect, each layer of each said layer pair is approximately 7Å thick.

According to another embodiment of the third aspect, said structure is capable of emitting light at a wavelength of approximately 325 nm.

According to a forth aspect the present invention provides a method of manufacturing a semiconductor light emitting diode comprising the steps of:
forming over and in contact with a substrate a GaN template layer;
forming over and in contact with said GaN template layer a superlattice structure, said superlattice structure comprising a plurality of layer pairs, a first layer of said layer pairs being AIN and a second layer of said layer pairs being GaN; and
forming over said superlattice structure a multiple quantum well heterostructure of a composition including at least 25% aluminum.

According to an embodiment of the forth aspect, the method further comprises the steps of:
forming a contact layer over said multiple quantum well heterostructure;
securing a planar heat sink body to said contact layer; and
thereafter removing said substrate and said GaN template layer;
whereby said semiconductor light emitting diode may emit light generally perpendicularly to the plane of the heat sink body.

In a further embodiment of the forth aspect, the method further comprises the step of removing said superlattice structure.

In a further embodiment of the forth aspect, the method further comprises the steps of:
forming a contact layer over said multiple quantum well heterostructure;
securing a transfer substrate to said contact layer;
removing said substrate and said GaN template layer;
securing said semiconductor light emitting diode to a planar heat sink body at a surface opposite said transfer substrate; and
removing said transfer substrate from said semiconductor light emitting diode;
whereby said semiconductor light emitting diode may emit light generally perpendicularly to the plane of the heat sink body.

In a further embodiment of the forth aspect, the method further comprises the step of removing said superlattice structure.

In a further embodiment, said superlattice structure comprises at least 70 but no more than 90 layer pairs.

In a further embodiment each layer of each said layer pair is approximately 7Å thick.

In a further embodiment said light emitting diode is capable of emitting light at a wavelength of approximately 325 nm.

According to another aspect the invention provides a semiconductor light emitting diode structure of a type formed on a substrate, wherein said substrate is removed and said semiconductor light emitting diode is bonded to a heat sink structure. The structure further comprises:
first and second index guiding layers; and
a multiple quantum well heterostructure of a composition including at least 25% aluminum, formed between said first and second index guiding layers;
wherein said multiple quantum well heterostructure is substantially free from structural cracks.

In a further embodiment said structure is capable of emitting light at a wavelength of approximately 325 nm.

According to another aspect the invention provides a semiconductor light emitting diode structure of a type formed on a substrate, wherein said substrate is removed and said semiconductor light emitting diode is bonded to a heat sink structure, wherein the structure comprises:
first and second index guiding layers; and
a multiple quantum well heterostructure of composition In_{w}GaₓAl_{y}N_{z}, where w+x+y+z = 1, and where y ≥ 0.35, formed between said first and second index guiding layers;
wherein said multiple quantum well heterostructure is substantially free from structural cracks.

In a further embodiment said structure is capable of emitting light at a wavelength of approximately 325 nm.

### BRIEF DESCRIPTION OF THE DRAWINGS

These and other aspects, features, and advantages of the present invention will become apparent from the following detailed description and the appended drawings in which like reference numerals denote like elements between the various drawings, but which are not drawn to scale.
Fig. 1 is a cross-sectional view of a multiple quantum-well heterostructure light emitting diode, including a GaN/AIN superlattice, according to an embodiment of the present invention.
Figs. 2A-2F are illustrations of the steps involved in a laser lift-off (LLO) and etch process to produce a surface-emitting light emitting diode according to an embodiment of the present invention.
Fig. 3 is a detailed view of a GaN/AIN superlattice structure according to an embodiment of the present invention.
Fig. 4 is a scanning electron microscope (SEM) view of a partial multiple quantum-well heterostructure light emitting diode structure grown on GaN/sapphire template, including a GaN/AIN superlattice, according to an embodiment of the present invention.
Fig. 5 is a voltage versus current graph, showing acceptable device performance, for a deep UV light emitting diode grown on a GaN/sapphire template with a GaN/AIN superlattice strain relief structure according to the present invention.
Fig. 6 is a graph of the Emission spectra (wavelength versus light output), for a deep UV light emitting diode grown on a GaN/sapphire template with a GaN/AIN superlattice strain relief structure according to the present invention.
Figs. 7A-7D are SEM micrographs of a deep UV emitting diode grown on a GaN/sapphire template with the number of layers comprising the superlattice strain relief structure at zero, 20, 40, 60, and 80 layer pairs of GaN/AIN, respectively.
Figs. 8A-8F are illustrations of the steps involved in a laser lift-off (LLO) and etch process to produce a surface-emitting light emitting diode according to another embodiment of the present invention.

### DETAILED DESCRIPTION OF THE INVENTION

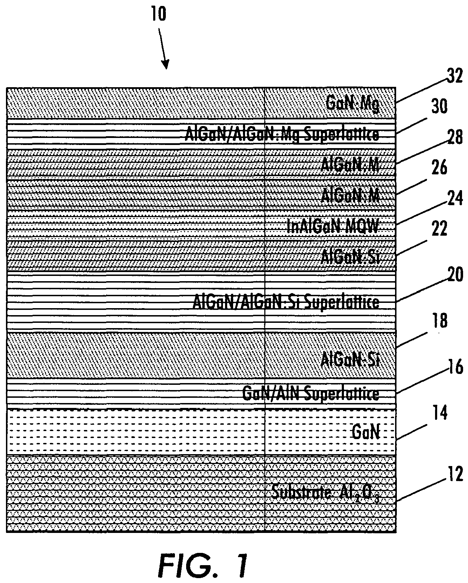

With reference now to Fig. 1, there is shown therein an index guided, buried heterostructure AlGaInN light emitting diode structure 10 in accordance with the present invention. Diode structure 10 comprises an Al₂O₃ (sapphire) substrate 12 on which is formed a 2-10 micron thick epitaxial GaN template layer 14. GaN template layer 14 can be Si-doped or undoped and is typically grown at approximately 1100 degree C and a reactor pressure of approximately 200 Torr. Formed thereon is a GaN/AIN superlattice layer 16, described further below. Formed next is AlGaN:Si buffer layer 18, and formed thereon is AlGaN/AlGaN:Si superlattice n-strain layer 20 which allows for increased cladding thickness and hence reduced optical leakage of subsequent layers. Formed next is AlGaN:Si n-cladding (index guiding) layer 22. InAIGaN multiple quantum well active layer 24 is formed on layer 22. Formed thereon is AlGaN:Mg p-cladding (index guiding) layer 26, then AlGaN:Mg buffer layer 28. AlGaN/AlGaN:Mg p-strain layer 30 is next deposited, then finally a GaN:Mg capping layer is formed over the structure. The aforementioned layers may be formed, for example, as described in the aforementioned incorporated U.S. Patent 6,875,627 to Bour et al. It will be appreciated that a complete device will also include electrodes, not shown, as well as other similar or alternative devices formed in the manner of an array in appropriate embodiments.

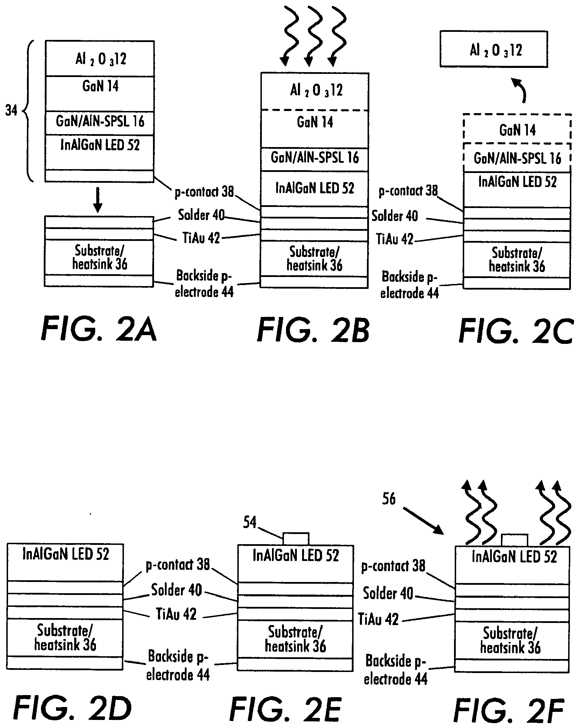

The structure produced is a light emitting diode designed, for example, to emit UV light through the substrate. Since the GaN template layer is absorptive at UV wavelengths, optimal device performance may be obtained by removal of substrate 12 and GaN template layer 14. This may preferably be accomplished by the method, referred to herein as a laser lift-off (LLO) process, described in U.S. Patent 6,757,314, which is incorporated by reference herein. One embodiment of an LLO method bonds a combination substrate/heat sink to a surface opposite the Al₂O₃ substrate. An excimer laser is typically employed to decouple the Al₂O₃ substrate from the GaN layer, allowing removal of the substrate, the GaN layer is then removed by a chemical process (e.g., dry etch). Some or all of GaN/AIN superlattice layer 16 is also removed by the chemical process at this point. A variation on this method first bonds an intermediate wafer to a surface opposite the Al₂O₃ substrate. The Al₂O₃ substrate and GaN layer are removed, and the device is then bonded to one of a variety of UV transparent substrates at the surface previously occupied by the GaN layer and Al₂O₃ substrate. An example of such a process for removing the substrate and GaN template layer is illustrated in Figs. 2A-2F, which merely schematically illustrate the light emitting diode according to the present invention (i.e., not all layers thereof are shown in these figures.)

With reference first to Fig. 2A, a light emitting diode 34 (or an array of such devices) of a type described above is indirectly secured (e.g., flip-chip, thermally, or acoustically bonded) to a substrate 36 with high thermal conductivity (such as copper, diamond, bulk AIN, or silicon) to serve as a heat sink. Ideally, the first metal contact 38 (p-contact) of the light emitting diode would be bonded to a solder 40/AuTi 42 layer pair on substrate/heatsink 36 (which may or may not be patterned), with the solder reflowing or deforming to form a permanent electrical, thermal, and mechanical contact/bond between the light emitting diode 34 and substrate/heat sink 36. In some cases the substrate/heatsink may be electrically conductive as well as thermally conductive, providing an electrical contact to the first contact 38 (p-contact) of the light emitting diode structure 34. In such cases an additional contact layer 44 may be placed on the backside of the substrate/heatsink 36 to improve electrical contacting.

Reference is now made to Fig. 2B. With the light emitting diode structure 34 affixed to substrate/heatsink 36, an excimer laser is scanned over the Al₂O₃ substrate 12. Due to the bandgap between GaN and its surrounding materials, there is high absorption of the light at the interface between the Al₂O₃ substrate 12 and the GaN layer 14. This effectively results in decomposition of the GaN material at the sapphire/GaN interface, weakening or breaking the bond between the two layers. A second step to melt the transformed interface (typically at temperatures greater than the melting point of Ga (Tm ∼ 30 C°) will further weaken the interface bond. With the bond sufficiently weakened, the Al₂O₃ substrate 12 may simply be mechanically removed from the light emitting diode structure 34, as shown in Fig. 2C.

The residual GaN layer 14 (typically several microns thick) and some or all of the GaN/AIN superlattice 16 are then removed using a dry etch (e.g., CAIBE) or possibly wet etching method. The structure is then substantially as shown in Fig. 2D. A second electrical contact 54 (n-contact) is then patterned directly on the exposed InAIGaN light emitting diode structure 52. This may be achieved in a variety of ways including (but not limited to) standard photolithography or a shadow mask processes. The structure is then as shown in Fig. 2E. The final light emitting diode structure 56 permits light extraction through an upper surface, and electrical contact directly to the light emitting diode active region via the contacts 44, 54 placed in direct contact on opposite sides of the active region.

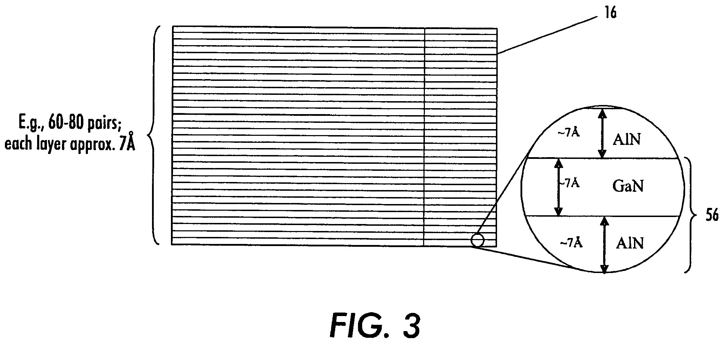

With reference now to Fig. 3, there is shown therein an exemplary embodiment of GaN/AIN superlattice 16, with layers grown in matched pairs 56 with GaN grown on top of AIN (that is, AIN is grown first upon GaN layer 14, then a layer of GaN, then another layer of AIN, and so forth with GaN as the final layer in the superlattice 16, and upon which AIGaN layer 18 is grown). Each of the superlattice pairs consists of an approximately 7Å wide GaN layer and an approximately 7Å wide AlN layer. The AlN and GaN layers are grown at approximately 1100 degree C° and approximately 200 Torr reactor pressure. The growth rate for the AIN and GaN layer was approximately ∼0.5 Å /sec. Superlattice layer 16 is nominally undoped, but could be doped (e.g., Si) by methods known in the art.

It will be appreciated that a critical role of GaN/AIN superlattice 16 is to permit the incorporation of higher amounts of Al in subsequently deposited layers than previously possible, due to the reduced defects in layers deposited over superlattice 16. However, forming each component layer of the superlattice 16 requires setting of processing equipment controls and the introduction of constituent components, thus taking time and consuming processing resources. Therefore, there is a balance to be struck between growing a minimal number of layer pairs to simplify processing and a sufficient number of pairs to allow for a crack-free high Al content heterostructure.

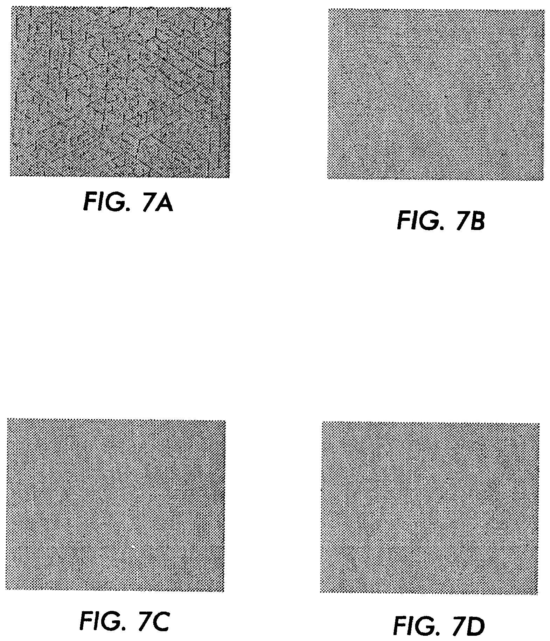

In quantifying this balance, the number of GaN/AIN superlattice pairs was varied between 20 and 80. Upon completion of a UV light emitting diode structure of the type described with regard to Fig. 1, with an Al mole fraction of the AIGaN layers at 25-40%, substrate 12, GaN template layer 14, and superlattice 16 were removed by processes described above and in aforementioned U.S. Patent 6,757,314. The remaining completed devices were examined for structural integrity, and surface condition of AIGaN layer 18. (It is critical that AIGaN layer 18 be crack free so as to provide a suitable foundation for the subsequent layers, and further that the multiple quantum well heterostructure active layer be crack free for device performance.) Furthermore, optical performance of each device was measured. A 20 pair superlattice 16 produced a device which exhibited significant surface irregularity and cracks in the layer 18. Structural cracking decreased in structures with 40 superlattice pairs, but still showed some surface irregularity and cracks. Optimal results (freedom from structural cracks, surface smoothness, light emitting diode performance, minimal number of layer pairs) were obtained for a structure which included a superlattice 16 consisting of 80 GaN/AIN pairs. At 80 superlattice pairs layer 18 showed virtually no detectable damage or cracks. Table 1 summarizes these results. Figs. 7A-7D are SEM micrographs showing the visible results for this experiment.

**Table 1**

| Number Of AlN/GaN Superlattice Pairs (All 7 Å /7 Å) | Surface After Led Growth On GaN/Sapphire | Light Emitting Diode Wavelength | Light Emitting Diode Relative Intensity | SEM Photograph |
|---|---|---|---|---|
| 0 | Extremely heavily cracked | Inoperable | inoperable | Fig. 7A |
| 20 | Heavily cracked | 328.8nm | 1 | Fig. 7B |
| 40 | A few cracks | 329.8nm | 1.45 | Fig. 7C |
| 80 | Good, No cracks | 328.3nm | 3.6 | Fig. 7D |

Appropriate thicknesses of the superlattice layers were also explored by varying each layer thickness between 7 and 14 Å for each of the GaN the AlN layers. The devices were prepared as previously described, and the surface of layer 18 examined. The cracking seemed not to be affected by a change of superlattice layer thickness, although the x-ray diffraction examination (XRD) at full-width half-maximum (FWHM) was the narrowest for the case in which each of the GaN and AlN layers were each 7Å in thickness. Table 2 summarize these results.

**Table 2**

| AIN/GaN Superlattice Thickness (All 80 Pairs) | (0006) XRD FWHM Of AlGaN Epitaxial Layer On GaN |
|---|---|
| 7/7 Å | 366"-785" |
| 7/14 Å | 418"-680" |
| 14/7 Å | 576" |

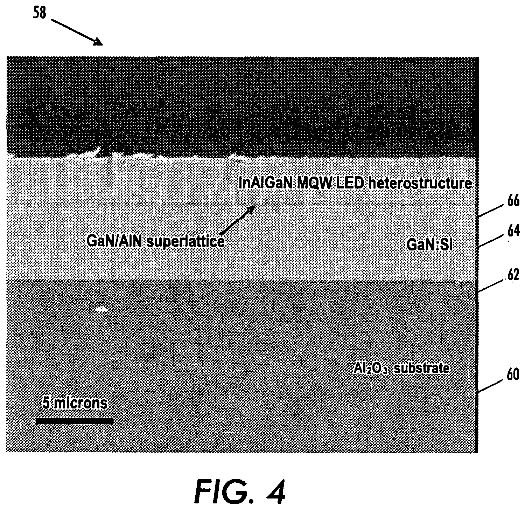

Fig. 4 shows a cross-sectional SEM image of a UV light emitting diode heterostructure 58, capable of emission at 325nm. Layers not specifically shown in Fig. 4 are either too thin to be seen in the SEM image or have low contrast (because of layer doping) as compared with nearby layers. (E.g. The contact layer on top of the structure is only 20nm and can not be seen in the SEM picture). Structure 58 includes an Al2O3 substrate 60, a GaN:Si template layer 62 formed on and over substrate 60, an 80 layer-pair GaN/AIN superlattice 64 formed on and over GaN:Si layer 62, and an InAlGaN multiple quantum well heterostructure layer 66 formed on and over superlattice 64. Each layer in superlattice 64 is approximately 7Å thick. The Al content in layer 66 was in the range of 35-40%. As can be seen, in cross section no cracks are visible in layer 66, a feature attributable to the provision of superlattice 64 thereunder.

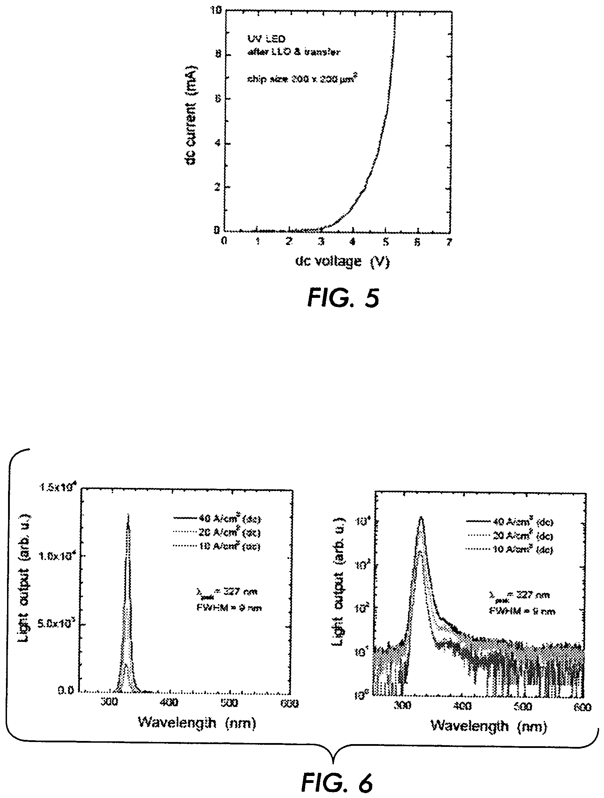

With reference to Fig. 5 device voltage versus current performance is shown for a deep UV light emitting diode grown on a GaN/sapphire template with a GaN/AIN superlattice strain relief structure according to the present invention (performance measured after removal of the substrate, etching of the GaN and GaN/AIN superlattice and transfer onto a quartz wafer) with peak emission around 327nm. Likewise, with reference to Fig. 6, shown therein is the emission spectra of the UV light emitting diode whose voltage-current data is shown in Fig. 5. The characterization data shows that after LLO and transfer of the device to a quartz substrate, the Deep UV LED still has good device performance, i.e. good IV performance, and narrow and clean emission spectra which indicate overall good material and device quality.

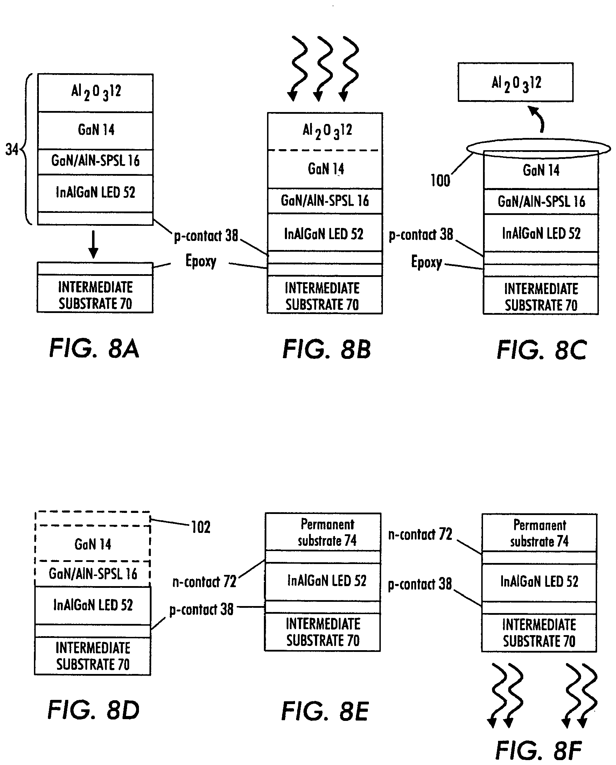

According to another embodiment for the production of a surface emitting LED shown in Figs. 8A through 8F, a UV LED structure is transferred in fabrication from a sapphire substrate to UV transparent material/substrate via an intermediate host substrate. The intermediate host substrate may be quartz, a flex substrate that facilitates integration of the LED device into larger systems, etc.

Initially, an intermediate (possibly UV transparent) substrate 70 is bonded to a surface of the UV LED structure opposite the sapphire substrate using an adhesive/epoxy, as shown in Fig. 8A. A LLO procedure is performed (as described previously), removing the sapphire substrate from the GaN layer, as shown in Figs. 8B and 8C. Etching then removes GaN layer 14 (optionally a sacrificial planarizaing layer 102 may be applied prior to etching), leaving the LED active region 52 (as well as additional layers) on the intermediate substrate, as shown in Fig. 8D. An n-contact layer 72 is then formed over the LED active region 52. Permanent substrate 74 is then bonded using a UV transparent epoxy (e.g., Epotek 301-2FL) to n-contact layer 72 (or alternatively, the substrate may form the n-contact, in which case substrate 74 is bonded directly to LED active region 52), as shown in Fig. 8E. In some instances a protective layer(s) may be applied to the lateral sides of the LED to insure the UV transparent epoxy does not bond with the intermediate substrate.

Two optional embodiments are now possible, each illustrated in Fig. 8F. In the first, the LED structure is released from the intermediate substrate 58 by emersion in a solvent (e.g., acetone) that dissolves the epoxy bonding the intermediate substrate 58 to the structure. Intermediate substrate 58 is then removed, leaving a device in which electrical contact is made from the top while light is extracted from the bottom of the device. In the second, intermediate substrate is UV transparent, and need not be removed. This also produces a device in which electrical contact is made from the top while the light is extracted from the bottom.

According to the present invention, a GaN/AIN strain relief layer formed over a GaN/sapphire template facilitates the formation of a substantially defect-free relatively high Al-content layer thereover. While particularly useful in optical systems, the present invention may also find applicability in non-optical systems. For example, copending U.S. Patent application serial number 10/952,202, which is incorporated by reference herein, discloses high electron mobility transistors (HEMTs) in which a relatively high Al-content AIGaN buffer layer is formed below an undoped GaN layer. The provision of a GaN/AIN strain relief layer in such a system may provide an improved quality AIGaN layer and hence improved quality GaN layer, ultimately providing improved device performance. Accordingly, another embodiment of the present invention provides a GaN/AIN strain relief layer for the growth of low defect, relatively high Al-content films over a GaN/sapphire template useful for non-optical applications.

In a preferred embodiment of the present invention, a GaN/AIN superlattice is formed over a GaN/sapphire template to serve in part as a strain relief layer for growth of deep UV light emitting diodes. Furthermore, it has been demonstrated that a GaN/AIN superlattice can be successfully used to mitigate the strain between a GaN/sapphire template and a high Al mole fraction deep UV light emitting diode heterostructure. Deep UV light emitting diodes have successfully been grown using this technique and working light emitting diodes have been demonstrated, including devices having a substrate removed by excimer laser lift-off.

## Claims

1. A semiconductor light emitting diode structure (52) of a type formed on a support (12, 14, 16), wherein said semiconductor light emitting diode (52) is bonded to a heat sink structure (36), comprising:
first and second index guiding layers (22, 26) formed over an AlGaN/AlGaN superlattice layer (20); and
a multiple quantum well heterostructure (24) of a composition including at least 25% aluminum, formed between said first and second index guiding layers (22, 26);
wherein the support comprises a substrate (12), a template layer (14) comprising GaN formed over and in contact with said substrate (12) and a superlattice structure (16) formed over and in contact with said template layer (14), said superlattice structure (16) comprising a plurality of layer pairs, a first layer of said pairs being AIN and a second layer of said layer pairs being GaN,
so that
said multiple quantum well heterostructure (24) is free from structural cracks.

2. The semiconductor light emitting diode structure of claim 1, wherein said structure is capable of emitting light at a wavelength of 325 nm.

3. A semiconductor light emitting diode structure as claimed in one of claims 1 and 2,
wherein
the composition of said multiple quantum well heterostructure is In_{w}GaₓAl_{y}N_{z}, where w+x+y+z = 1, and where y ≥ 0.35.

4. The semiconductor light emitting diode structure of claim 1, wherein the template layer has a thickness of 2 to 10 microns.

5. The semiconductor light emitting diode structure of claim 1, wherein a number of layer pairs of the AlN/GaN superlattice is 60 to 80 pairs.

6. The semiconductor light emitting diode structure of claim 1, wherein each of the layers of the pairs of the AlN/GaN superlattice structure has a thickness of approximately 7 angstroms.

## Patentansprüche

1. Halbleiter-Leuchtdiodenstruktur (52) eines Typs, der auf einem Träger (12, 14, 16) ausgebildet ist, wobei die Halbleiter-Leuchtdiode (52) an eine Wärmesenken- Struktur (36) gebondet ist, und wobei sie umfasst:
eine erste und eine zweite Indexführungs-Schicht (22, 26), die über einer AlGaN/AlGaN-Suppergitter-Schicht (20) ausgebildet sind; sowie
eine Multiple-Quantum-Well-Heterostruktur (24) aus einer Zusammensetzung, die wenigstens 25% Aluminium enthält, die zwischen der ersten und zweiten Indexführungs-Schicht (22, 26) ausgebildet ist;
wobei
der Träger ein Substrat (12), eine GaN umfassende Template-Schicht (14), die über sowie in Kontakt mit dem Substrat (12) ausgebildet ist, sowie eine Supergitter-Struktur (16) umfasst, die über und in Kontakt mit der Template-Schicht (14) ausgebildet ist, wobei die Supergitter-Struktur (16) eine Vielzahl von Schicht-Paaren umfasst, wobei eine erste Schicht der Paare AIN ist und eine zweite Schicht der Schicht-Paare GaN ist,
so dass
die Multiple-Quantum-Well-Heterostruktur (24) frei von strukturellen Rissen ist.

2. Halbleiter-Leuchtdiodenstruktur nach Anspruch 1, wobei die Struktur in der Lage ist, Licht bei einer Wellenlänge von 325 nm zu emittieren.

3. Halbleiter-Leuchtdiodenstruktur nach einem der Ansprüche 1 und 2, wobei
die Zusammensetzung der Multiple-Quantum-Well-Heterostruktur aus In_{w}GaxAl_{y}N_{z} besteht, dabei w + x + y + z = 1 gilt und y ≥ 0,35.

4. Halbleiter-Leuchtdiodenstruktur nach Anspruch 1, wobei die Template-Schicht eine Dicke von 2 bis 10 µm hat.

5. Halbleiter-Leuchtdiodenstruktur nach Anspruch 1, wobei eine Anzahl von Schicht-Paaren des AIN/GaN-Supergitters 60 bis 80 Paare beträgt.

6. Halbleiter-Leuchtdiodenstruktur nach Anspruch 1, wobei jede der Schichten der Paare der AIN/GaN-Supergitter-Struktur eine Dicke von ungefähr 7 Å hat.

## Revendications

1. Structure de diode électroluminescente à semiconducteurs (52) d'un type formé sur un support (12, 14, 16), dans laquelle ladite diode électroluminescente à semiconducteurs (52) est liée à une structure de dissipateur de chaleur (36), qui comprend :
des couches de guidage à premier et deuxième indices (22, 26) formées sur une couche de super-réseau en AlGaN/AlGaN (20) ; et
une hétérostructure à multiples puits quantiques (24) d'une composition qui comprend au moins 25 % d'aluminium, formée entre lesdites couches de guidage à premier et deuxième indices (22, 26) ;
dans laquelle
le support comprend un substrat (12), une couche de modèle (14) qui comprend du GaN formée sur et en contact avec ledit substrat (12) et une structure de super réseau (16) formée sur et en contact avec ladite couche de modèle (14), dans laquelle ladite structure de super réseau (16) comprend une pluralité de paires de couches, une première couche desdites paires est en AlN et une deuxième couche desdites paires de couches est en GaN,
de sorte que
ladite hétérostructure à multiples puits quantiques (24) est exempte de fissures structurelles.

2. Structure de diode électroluminescente à semiconducteurs selon la revendication 1, dans laquelle ladite structure est capable d'émettre une lumière à une longueur d'onde de 325 nm.

3. Structure de diode électroluminescente à semiconducteurs selon l'une des revendications 1 et 2, dans laquelle
la composition de ladite hétérostructure à multiples puits quantiques est In_{w}GaₓAl_{y}N_{z}, où w+x+y+z = 1, et où y ≥ 0,35.

4. Structure de diode électroluminescente à semiconducteurs selon la revendication 1, dans laquelle la couche de modèle a une épaisseur de 2 à 10 microns.

5. Structure de diode électroluminescente à semiconducteurs selon la revendication 1, dans laquelle un nombre de paires de couches du super-réseau en AlN/GaN est de 60 à 80 paires.

6. Structure de diode électroluminescente à semiconducteurs selon la revendication 1, dans laquelle chacune des couches des paires de la structure de super réseau en AlN/GaN a une épaisseur d'environ 7 angströms.
